# EUROPEAN PATENT APPLICATION

(11) **EP 2 754 618 A1**
(43) Date of publication of application: **16.07.2014**
(21) Application number: 12829733.0
(22) Date of filing: 06.09.2012
(51) Int. Cl.: B65D 25/14, B65D 65/40, B32B 27/06, A47G 19/02

(54) **FOOD CONTAINER HAVING NANOSTRUCTURED HYDROPHOBIC SURFACE AND MANUFACTURING METHOD THEREOF**

(30) Priority: 08.09.2011 KR 20110091338
(71) Applicant: CJ Cheiljedang Corporation, Jung-gu Seoul 100-400 (KR); Korea Institute of Science and Technology, Seoul 136-130 (KR)
(72) Inventor: SONG, Eun Kyung, Goyang-si Gyeonggi-do 411-764 (KR); JO, Kyoung Sik, Seoul 158-774 (KR); LEE, Jin Hwan, Ansan-si Gyeonggi-do 425-020 (KR); YUN, Tae Kyung, Seoul 138-902 (KR); LEE, Kwang Ryeol, Seoul 137-060 (KR); MOON, Myoung Woon, Seoul 136-130 (KR); KIM, Seong Jin, Seoul 151-847 (KR)
(74) Representative: Mounteney, Simon James
(86) International application number: PCT/KR2012/007177
(87) International publication number: WO 2013/036042

(57) **Abstract**

The present invention relates to a food container made of a plastic material and having a nano-structured hydrophobic surface, including: a plurality of nano-structures formed on a surface of the food container; and a first hydrophobic thin film coated on an upper side of the surface, on which the nano-structures are formed, and a manufacturing method thereof. According to the present invention, it is possible to provide the food container having the nano-structured hydrophobic surface capable of having excellent gas blocking performance, as well as hydrophobicity, and the manufacturing method thereof.

## Description

### [Technical Field]

The present invention relates to a food container and a manufacturing method thereof, and more particularly, to a food container having a nano-structured hydrophobic surface having hydrophobicity and a gas blocking property, and a manufacturing method thereof.

### [Background Art]

Recently, a food container, which is used for storing food and the like, is mainly formed of a plastic material, such as polypropylene (PP) or polyethylene terephthalate (PET) by reason of manufacturing easiness and a low cost.

A plastic material having relatively low surface energy is a hydrophilic material having a contact angle of 50 to 80° with respect to pure water.

A fact that a surface has hydrophilicity means that the surface prefers a contact with water to a contact with air, and water attached to the surface has a wide contact area with the surface and is not well separated from the surface. That is, food is stably attached to the surface.

In a case where an attachment degree of food is high, a stain is generated on a surface of the food container even after the food is removed, and further, there is a problem in that food residue is left on the surface of the food container by the stable contact between the surface of the food container and the food.

### [Disclosure]

### [Technical Problem]

An object of the present invention is to provide a food container having a nano-structured hydrophobic surface capable of preventing a stain generated due to a contact of food containing water with a surface of the food container, decreasing food residual left on the surface of the food container, and preventing a harmful influence from the food container by minimizing a contact area of food and the food container, and a manufacturing method thereof.

### [Technical Solution]

In order to achieve the aforementioned object, the present invention provides a food container made of a plastic material and having a nano-structured hydrophobic surface, including: a plurality of nano-structures formed on a surface of the food container; and a first hydrophobic thin film coated on an upper side of the surface, on which the nano-structures are formed.

Further, the food container may further include a gas blocking film formed between the surface of the food container and the first hydrophobic thin film.

Further, the food container may further include a second hydrophobic thin film formed between the surface of the food container and the gas blocking film.

Further, the nano-structure may have any one shape among a nano-pillar shape, a nano-rod shape, a nano-dot shape, and a nano-wire shape.

Further, the nano-structure may have a width of 1 to 100 nm and a height of 1 to 1000 nm.

Further, a contact angle of the first hydrophobic thin film may be equal to or larger than 90°, and contact angle hysteresis of the first hydrophobic thin film may be less than 30°.

Further, a sum of a thickness of the first hydrophobic thin film and a thickness of the gas blocking film may be a half of a height of the nano-structure or lower.

Further, a sum of a thickness of the first hydrophobic thin film, a thickness of the gas blocking film, and a thickness of the second hydrophobic thin film may be a half of a height of the nano-structure or lower.

Further, the first hydrophobic thin film is formed of hexamethyldisiloxane

Further, the gas blocking film may be formed of silicon oxide.

Further, the second hydrophobic thin film may be formed of hexamethyldisiloxane

Further, the gas blocking film and the first and second hydrophobic thin films may be discontinuously combined.

Further, the gas blocking film and the first and second hydrophobic thin films may be continuously combined according to a continuous change in mutual chemical composition.

A method of manufacturing a food container having a nano-structured hydrophobic surface of the present invention includes: forming a plurality of nano-structures on a surface of the food container formed of a plastic material; and coating a first hydrophobic thin film on an upper side of the surface, on which the nano-structures are formed.

Further, the method may further include coating a gas blocking film on the upper side of the surface, on which the nano-structures are formed, between the forming of the plurality of nano-structures and the coating of the first hydrophobic thin film.

Further, the method may further include coating a second hydrophobic thin film on the upper side of the surface, on which the nano-structures are formed, between the forming of the plurality of nano-structures and the coating of the gas blocking film.

Further, the nano-structure may have any one shape among a nano-pillar shape, a nano-rod shape, a nano-dot shape, and a nano-wire shape.

Further, the nano-structure may have a width of 1 to 100 nm and a height of 1 to 1000 nm.

Further, a contact angle of the first hydrophobic thin film may be equal to or larger than 90°, and contact angle hysteresis of the first hydrophobic thin film may be less than 30°.

Further, a sum of a thickness of the first hydrophobic thin film and a thickness of the gas blocking film may be a half of a height of the nano-structure or lower.

Further, a sum of a thickness of the first hydrophobic thin film, a thickness of the gas blocking film, and a thickness of the second hydrophobic thin film may be a half of a height of the nano-structure or lower.

Further, the first hydrophobic thin film may be formed of hexamethyldisiloxane Further, the gas blocking film may be formed of silicon oxide.

Further, the second hydrophobic thin film may be formed of hexamethyldisiloxane

Further, the gas blocking film and the first and second hydrophobic thin films may be discontinuously combined.

Further, the gas blocking film and the first and second hydrophobic thin films may be continuously combined according to a continuous change in mutual chemical composition.

### [Advantageous Effects]

As described above, according to the present invention, it is possible to provide the food container having the nano-structured hydrophobic surface capable of preventing a stain generated due to a contact of food containing water with a surface of the food container, decreasing food residual left on the surface of the food container, and preventing a harmful influence from the food container by minimizing a contact area of food and the food container, and a manufacturing method thereof.

Further, according to the present invention, it is possible to provide the food container having the nano-structured hydrophobic surface capable of having excellent gas blocking performance, as well as hydrophobicity, by additionally forming the gas blocking film, and the manufacturing method thereof.

### [Description of Drawings]

FIG. 1A is a diagram illustrating a food container having a nano-structured hydrophobic surface according to a first exemplary embodiment of the present invention.
FIG. 1B is a diagram illustrating a method of manufacturing the food container illustrated in FIG. 1A.
FIG. 2A is a diagram illustrating a food container having a nano-structured hydrophobic surface according to a second exemplary embodiment of the present invention.
FIG. 2B is a diagram illustrating a method of manufacturing the food container illustrated in FIG. 2A.
FIG. 3A is a diagram illustrating a food container having a nano-structured hydrophobic surface according to a third exemplary embodiment of the present invention.
FIG. 3B is a diagram illustrating a method of manufacturing the food container illustrated in FIG. 3A.
FIG. 4 is a graph illustrating a static contact angle between water, vinegar, and soy sauce measured according to a time of oxygen plasma processing performed on the food container.
FIG. 5A is a graph illustrating a dynamic contact angle of water according to a time of oxygen plasma processing performed on the food container.
FIG. 5B is a graph illustrating a dynamic contact angle of vinegar according to a time of oxygen plasma processing performed on the food container.
FIG. 5C is a graph illustrating a dynamic contact angle of soy sauce according to a time of oxygen plasma processing performed on the food container.

### [Best Mode]

Other detailed matters of the exemplary embodiments are included in the detailed description and the drawings.

Various advantages and features of the present disclosure and methods accomplishing thereof will become apparent from the following detailed description of exemplary embodiments with reference to the accompanying drawings. However, the present invention is not limited to the exemplary embodiments set forth below, and may be embodied in various other forms. The present exemplary embodiments are for rendering the description of the present invention complete and are set forth to provide a complete understanding of the scope of the invention to a person with ordinary skill in the technical field to which the present invention pertains, and the present invention will only be defined by the scope of the claims. Like reference numerals indicate like elements throughout the specification.

Hereinafter, a food container having a nano-structured hydrophobic surface and a method of manufacturing the same according to the present invention will be described with reference to the exemplary embodiment of the present invention and the drawings for describing the exemplary embodiment of the present invention.

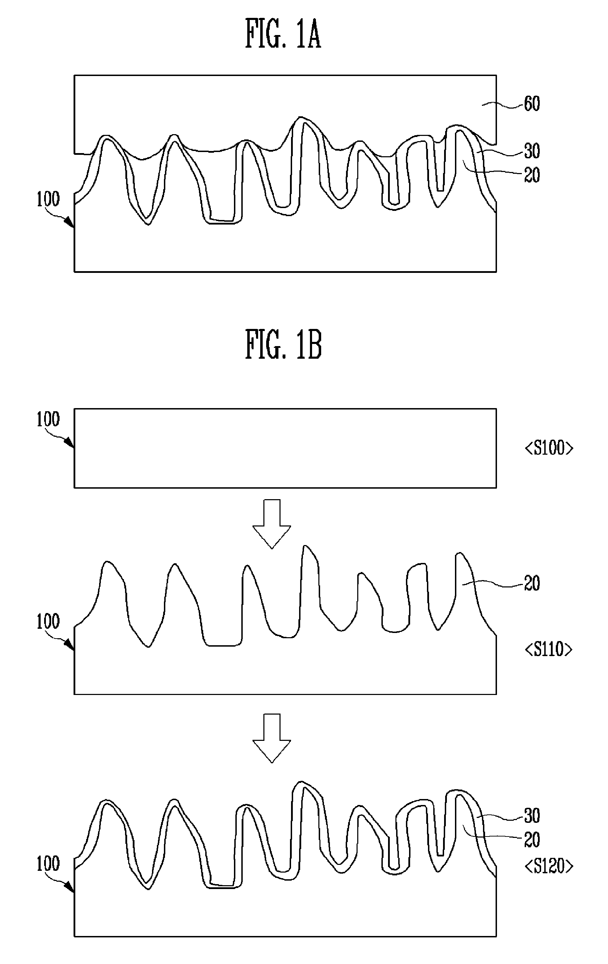

FIG. 1A is a diagram illustrating a food container having a nano-structured hydrophobic surface according to a first exemplary embodiment of the present invention.

Referring to FIG. 1A, a food container 100 having a nano-structured hydrophobic surface (hereinafter, referred to as a "food container") according to a first exemplary embodiment of the present invention includes a plurality of nano-structures 20 and a first hydrophobic thin film 30.

The food container 100 is formed of a plastic material, such as polypropylene (PP), polyethylene terephthalate (PET), polyethylene (PE), polystyrene (PS) and the like.

In order to solve a problem (the food container 100 has hydrophilicity, so that food is attached to the food container 100) of the food container 100 formed of the plastic material, the food container 100 according to the exemplary embodiment is formed of the plurality of nano-structures 20 on a surface thereof.

That is, an air membrane is stably positioned in a space between the respective nano structures 20, so that the surface of the food container 100 has a very small contact area with food 60 containing water. Accordingly, the surface of the food container 100 has the hydrophobicity.

Further, in order to improve the hydrophobicity of the surface of the food container 100, a first hydrophobic thin film 30 may be coated on an upper side of the surface of the food container 100, on which the nano-structures are formed.

The first hydrophobic thin film 30 may be implemented by a material, which has low surface energy to have hydrophobicity, and may be preferably implemented by hexamethyldisiloxane (HMDSO), but may also adopt polytetrafluoroethylene (PTFE) or alkyl keton dimer (AKD), which is a conventionally well-known hydrophobic thin film.

Further, in the food container 100 in the present exemplary embodiment, a contact angle of a water drop, which is in contact with the first hydrophobic thin film 30, is 90° or more through the forming of the nano-structures 20 and the first hydrophobic thin film 30, and contact angle hysteresis is also less than 30°.

A contact angle is defined as an angle between a liquid surface and a solid surface in a liquid and a solid which are in contact with each other, and is generally represented by an angle formed between a tangent line from a contact point of a droplet and a solid leaded to a droplet surface and the solid surface. The contact angle is used as a criterion indicating wettability of the solid surface.

That is, as a contact angle is small, hydrophilicity is large, and as a contact angle is large, hydrophobicity is large.

Contact angle hysteresis may be defined by a difference between an advancing contact angle, at which a liquid starts to move forward from the surface, and a receding contact angle, at which the liquid starts to move backward from the surface, and the fact that a value of the contact angle hysteresis is large means that a liquid is not well detached from a surface, and the fact that a value of the contact angle hysteresis is small means that a liquid is well detached from a surface.

Accordingly, as described above, the contact angle of the first hydrophobic thin film 30 may be formed to be 90° or greater to achieve hydrophobicity, and the contact angle hysteresis may be formed to be less than 30°, thereby making the food 60 be well detached from the surface of the food container 100.

Here, the shape of the nano-structure 20 may be variously implemented, and an example thereof may include any one of a nanopillar shape, a nanorod shape, a nanodot shape, and a nanowire shape.

Further, a width of the nano-structure 20 may be set to be 1 to 100 nm, and a height thereof may be set to be 1 to 1000 nm.

FIG. 1B is a diagram illustrating a method of manufacturing the food container illustrated in FIG. 1A. That is, a method of manufacturing the food container 100 according to the first exemplary embodiment of the present invention includes a food container preparing step S100, a nano-structure forming step S110, and a first hydrophobic thin film coating step S120.

First, in the food container preparing step S100, the food container 100, which is formed of a plastic material and has a flat surface, is prepared.

Then, the nano-structure forming step S110 of forming the plurality of nano-structures 20 on the surface of the food container 100 is performed.

In the nano-structure forming step S110, dust on the surface of the food container 100 is removed by using a nitrogen gun (not shown). Then, the food container 100 is positioned within a chamber of Radio Frequency-Chemical Vapor Deposition (RF-CVD) equipment (not shown), and a vacuum state is formed.

A vacuum pressure within the chamber of the RF-CVD equipment is adjusted to a predetermined value by using a pump and the like, and plasma processing starts on the surface of the food container 100.

To this end, after oxygen gas is inserted into the chamber, a plasma state is generated by RF-power. Then, the plurality of nano-structures 20 is formed on the surface of the food container 100 by a chemical reaction between the food container 100 and oxygen plasma.

As the time of the oxygen plasma processing on the food container 100 is increased, a height of the nano-structure 20 is increased, and a width thereof is decreased. That is, the sharper and longer nano-structure is formed.

Next, the first hydrophobic thin film coating step S 120 is performed.

In the first hydrophobic thin film coating step S120, after the oxygen plasma processing performed in the nano-structure forming step S110 is completed, a first hydrophobic thin film forming material in a gas state is inserted into the chamber of the RF-CVD equipment. Then, the plasma state is generated by the RF-power again, so that the first hydrophobic thin film forming material in the gas state may be deposited on the surface of the food container 100 in which the nano-structures 20 are formed. Accordingly, the first hydrophobic thin film 30 is finally coated on the surface of the food container 100.

For example, when hexamethyldisiloxane (HMDSO) gas is inserted as the first hydrophobic thin film forming material, the first hydrophobic thin film 30 made of plasma polymerized HMDSO (pp-HMDSO) may be formed. The first hydrophobic thin film 30 made of plasma polymerized HMDSO (pp-HMDSO) has low surface energy to have hydrophobicity.

It is possible to manufacture the food container having hydrophobicity through the aforementioned manufacturing method, and thus it is possible to prevent a phenomenon in that liquid-state food is attached to the surface of the food container, thereby preventing a phenomenon in that a stain is generated on the surface of the food container and minimizing the amount of food left on the surface of the food container.

Further, it is possible to minimize a contact area between the food and the food container, thereby preventing harmful ingredients from being transferred from the food container to the food.

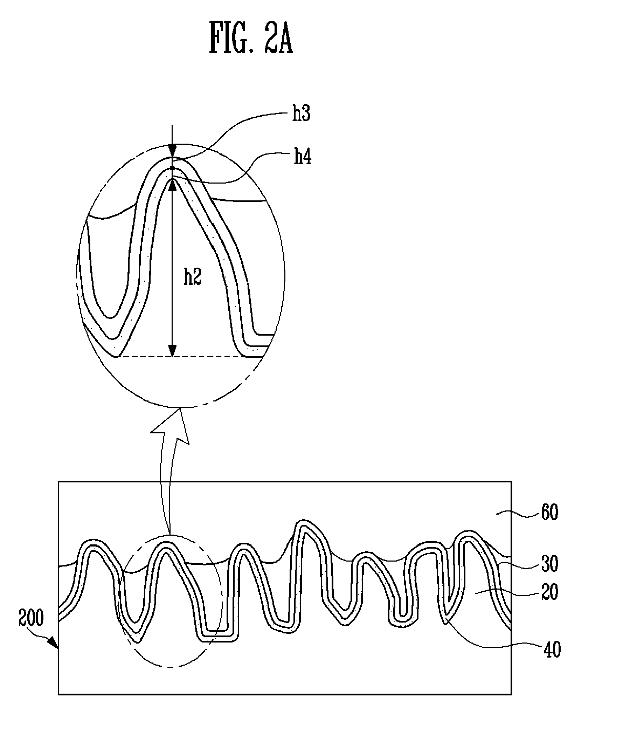

FIG. 2A is a diagram illustrating a food container having a nano-structured hydrophobic surface according to a second exemplary embodiment of the present invention.

Referring to FIG. 2A, a food container 200 having a nano-structured hydrophobic surface (hereinafter, referred to as a "food container") according to a second exemplary embodiment of the present invention includes a plurality of nano-structures 20, a first hydrophobic thin film 30, and a gas blocking film 40.

That is, the present exemplary embodiment is different from the first exemplary embodiment in that the gas blocking film 40 is further included, so that the present exemplary embodiment will be described based on the gas blocking film 40, and descriptions overlapping those of the first exemplary embodiment will be omitted.

The gas blocking film 40 is formed between the surface of the food container 200 and the first hydrophobic thin film 30.

Further, the first hydrophobic thin film 30 is coated on the surface of the food container 200 in which the gas blocking film 40 is formed.

The gas blocking film 40 is inserted between the food container 200 and the first hydrophobic thin film 30, so that the food container 200 according to the exemplary embodiment of the present invention may have excellent gas blocking performance. Accordingly, food stored inside the food container 200 may be preserved for a long time.

In this case, the gas blocking film 40 has a high thin film density, so that the gas blocking film 40 may be silicon oxide having excellent gas blocking performance.

Further, in a case where a sum of a thickness h3 of the first hydrophobic thin film 30 and a thickness h4 of the gas blocking film 40 is set to be excessively large, a space between the nano-structures 20 is decreased, thereby causing a problem in that hydrophobicity deteriorates, so that the sum of the thickness h3 of the first hydrophobic thin film 30 and the thickness h4 of the gas blocking film 40 may be set to be a half of a height h2 of the nano-structure 20 or smaller.

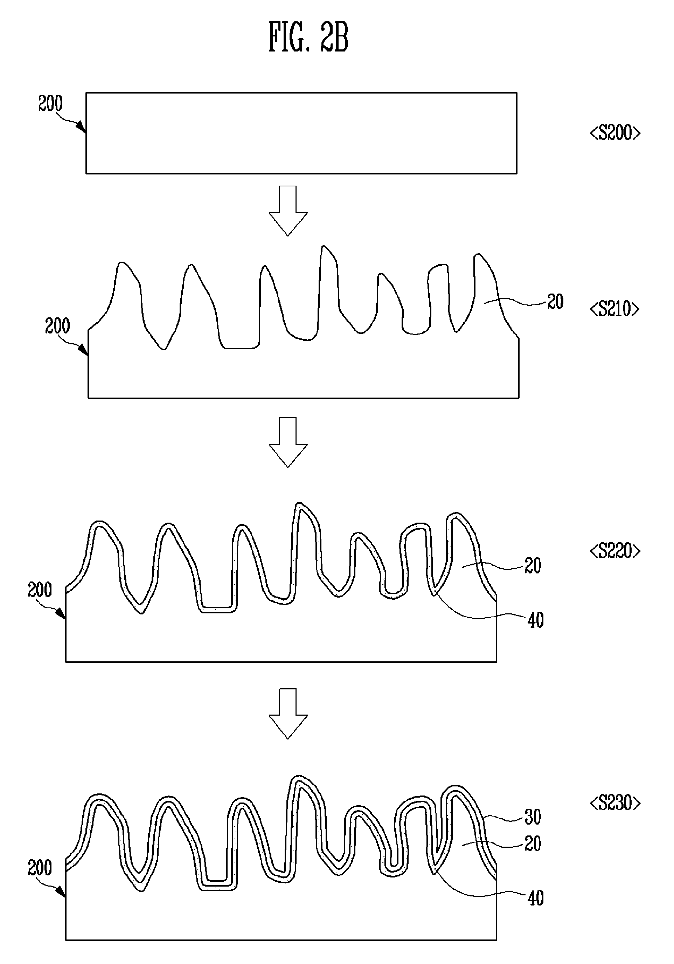

FIG. 2B is a diagram illustrating a method of manufacturing the food container illustrated in FIG. 2A. That is, a method of manufacturing the food container 200 according to the second exemplary embodiment of the present invention includes a food container preparing step S200, a nano-structure forming step S210, a gas blocking film coating step S220, and a first hydrophobic thin film coating step S230.

The food container preparing step S200 and the nano-structure forming step S210 are identically performed to those aforementioned the first exemplary embodiment.

Next, differently from the first exemplary embodiment, in the present exemplary embodiment, the gas blocking film coating step S220 is performed before the first hydrophobic thin film coating step S230.

In gas blocking film coating step S220, the gas blocking film 40 is coated on the surface of the food container 200 in which the nano-structures 20 are formed.

The process may be performed within the chamber of the RF-CVD equipment using plasma.

For example, the gas blocking film 40 has a high thin film density, so that the gas blocking film 40 may be silicon oxide having excellent gas blocking performance.

Then, the first hydrophobic thin film coating step S230 of coating the first hydrophobic thin film 30 on the gas blocking film 40 is performed.

The first hydrophobic thin film coating step S230 may be identically performed to that described in the first exemplary embodiment.

Here, the gas blocking film coating step S220 and the first hydrophobic thin film coating step S230 may be discontinuously or continuously performed.

According to the discontinuous process, the plasma state is released after the gas blocking film 40 is formed, and the plasma state is generated again after confirming that gas for coating the first hydrophobic thin film 30 stably flows into the chamber to coat the first hydrophobic thin film 30.

Accordingly, the gas blocking film 40 and the first hydrophobic thin film 30 are discontinuously combined so as to prevent mutual composition from being continuously changed.

In the meantime, according to the continuous process, the plasma state is continuously maintained even after the gas blocking film 40 is formed, and gas flowing into the chamber is continuously changed from gas forming the gas blocking film 40 to gas forming the first hydrophobic thin film 30.

According to the continuous process, it is possible to form a thin film structure in which composition is gradually changed from the gas blocking film 40 to the first hydrophobic thin film 30. That is, as another expression, it is possible to form a thin film structure in which thin films are continuously connected.

The continuous process may be used for reducing a time consumed for changing gas in a factory performing mass production, and has an effect in that difference in stress applied to the thin films is released during discontinuous deposition.

According to the aforementioned process, the nano-structures 20, the gas blocking film 40, and the first hydrophobic thin film 30 are sequentially positioned on the surface of the food container 200 as a result.

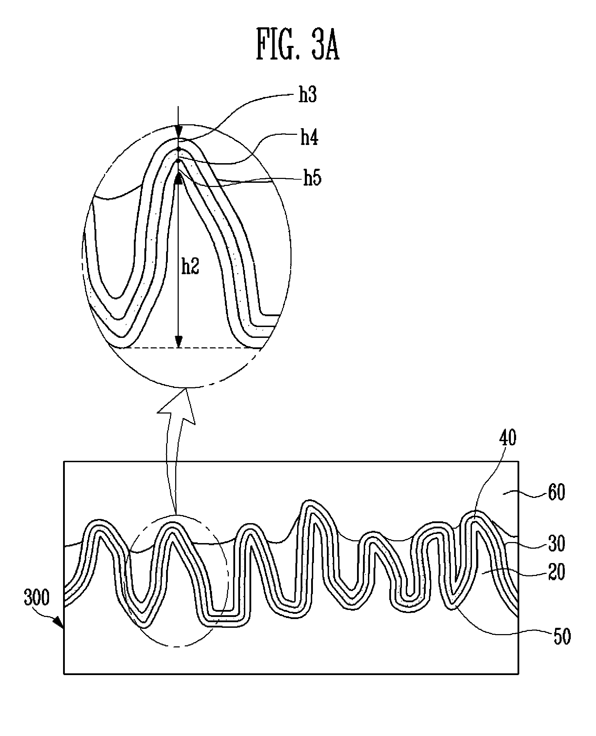

FIG. 3A is a diagram illustrating a food container having a nano-structured hydrophobic surface according to a third exemplary embodiment of the present invention.

Referring to FIG. 3A, a food container 300 having a nano-structured hydrophobic surface (hereinafter, referred to as a "food container") according to a third exemplary embodiment of the present invention includes a plurality of nano-structures 20, a first hydrophobic thin film 30, a gas blocking film 40, and a second hydrophobic thin film 50.

That is, the present exemplary embodiment is different from the second exemplary embodiment in that the second hydrophobic thin film 50 is further included, so that the present exemplary embodiment will be described based on the second hydrophobic thin film 50, and descriptions overlapping those of the second exemplary embodiment will be omitted.

The second hydrophobic thin film 50 is formed between a surface of the food container 300 and the gas blocking film 40. That is, the second hydrophobic thin film 50 is first coated on the surface of the food container 300, and then the gas blocking film 40 is formed on the second hydrophobic thin film 50.

Further, after the gas blocking film 40 is coated, and then the first hydrophobic thin film 30 is coated on the gas blocking film 40.

Accordingly, the second hydrophobic thin film 50, the gas blocking film 40, and the first hydrophobic thin film 30 are sequentially positioned on the nano-structures 20 of the food container 300.

When the gas blocking film 40 having flexibility is directly coated on the food container 300, there is a problem in that strong residual stress is left, and the second hydrophobic thin film 50 positioned at the lowermost side serves as a buffer thin film (buffer layer) for releasing the problem.

The second hydrophobic thin film 50 may be formed of the same material as that of the first hydrophobic thin film 30. Accordingly, the second hydrophobic thin film 50 may also be implemented by hexamethyldisiloxane (HMDSO), but may also adopt polytetrafluoroethylene (PTFE) or alkyl keton dimer (AKD), which is a conventionally well-known hydrophobic thin film.

Further, in a case where a sum of a thickness h3 of the first hydrophobic thin film 30, a thickness h4 of the gas blocking film 40, and a thickness h5 of the second hydrophobic thin film 50 is set to be excessively large, a space between the nano-structures 20 is decreased, thereby causing a problem in that hydrophobicity deteriorates, so that the sum of the thickness h3 of the first hydrophobic thin film 30, the thickness h4 of the gas blocking film 40, and a thickness h5 of the second hydrophobic thin film 50 may be set to be a half of a height h2 of the nano-structure 20 or smaller.

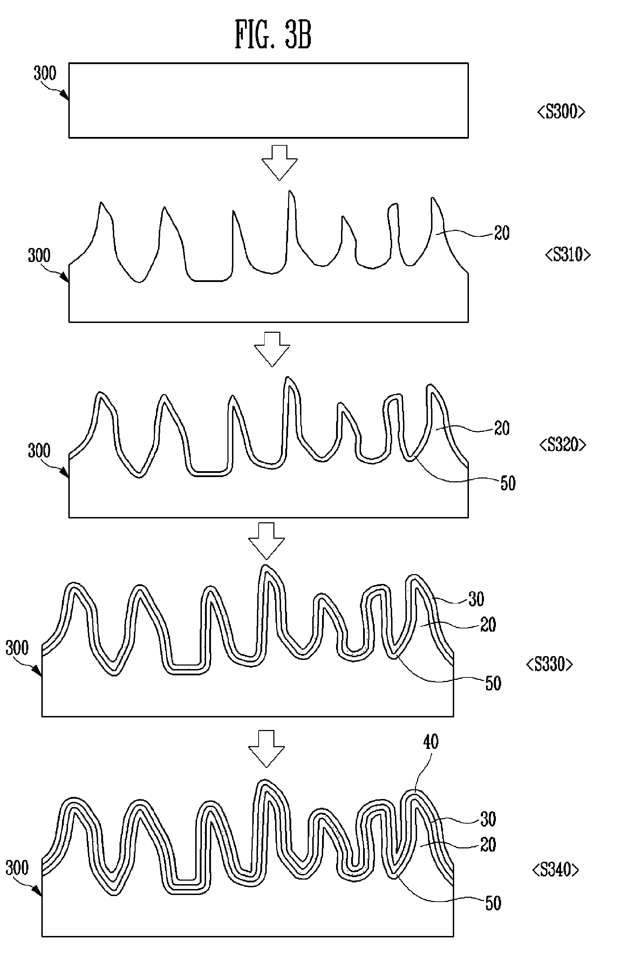

FIG. 3B is a diagram illustrating a method of manufacturing the food container illustrated in FIG. 3A. That is, a method of manufacturing the food container 300 according to the third exemplary embodiment of the present invention includes a food container preparing step S300, a nano-structure forming step S310, a second hydrophobic thin film coating step S320, a gas blocking film coating step S330, and a first hydrophobic thin film coating step S340.

The food container preparing step S300 and the nano-structure forming step S310 are identically performed to those aforementioned the first and second exemplary embodiments.

Next, differently from the second exemplary embodiment, in the present exemplary embodiment, the second hydrophobic thin film coating step S320 is performed before the gas blocking film coating step S330.

In the second hydrophobic thin film coating step S320, the second hydrophobic thin film 50 is coated on the surface of the food container 300 in which the nano-structures 20 are formed, which may be performed by the same method as that of the first hydrophobic thin film coating step S120 in the aforementioned first exemplary embodiment.

Then, the gas blocking film coating step S330 and the first hydrophobic thin film coating step S340 are sequentially performed equally to those of the second exemplary embodiment.

In the gas blocking film coating step S330, the gas blocking film 40 is coated on the second hydrophobic thin film 50, and in the first hydrophobic thin film coating step S340, the first hydrophobic thin film 30 is coated on the gas blocking film 40.

Here, the second hydrophobic thin film coating step S320, the gas blocking film coating step S330, and the first hydrophobic thin film coating step S340 may be discontinuously performed similar to the second exemplary embodiment, or may be continuously performed.

According to the discontinuous process, the plasma state is released after the second hydrophobic thin film 50 is formed, the plasma state is generated again after confirming that gas coated on the gas blocking film 40 stably flows into the chamber to form the gas blocking film 40, the plasma state is released after forming the gas blocking film 40, and the plasma state is generated again after confirming that gas coated on the first hydrophobic thin film 30 stably flows into the chamber to coat the first hydrophobic thin film 30.

Accordingly, the second hydrophobic thin film 50, the gas blocking film 40, and the first hydrophobic thin film 30 are discontinuously combined so as to prevent mutual composition from being continuously changed.

In the meantime, according to the continuous process, the plasma state is continuously maintained even after the second hydrophobic thin film 50 is formed, and gas flowing into the chamber is continuously changed from gas forming the second hydrophobic thin film 50 to the gas forming the gas blocking film 40. Further, the plasma state is continuously maintained even after the gas blocking film 40 is formed, and gas flowing into the chamber is continuously changed from gas forming the gas blocking film 40 to gas forming the first hydrophobic thin film 30.

According to the continuous process, it is possible to form a thin film structure in which composition is gradually changed from the second hydrophobic thin film 50 to the first hydrophobic thin film 30 via the gas blocking film 40. That is, as another expression, it is possible to form a thin film structure in which thin films are continuously connected.

The continuous process may be used for reducing a time consumed for changing gas in a factory performing mass production, and has an effect in that difference in stress applied to the thin films is released during discontinuous deposition.

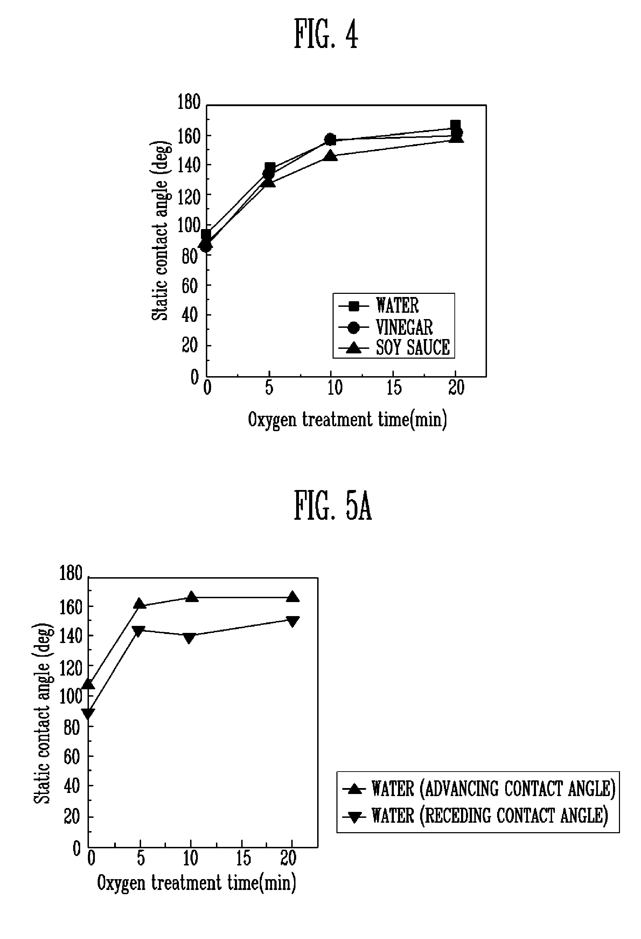

FIG. 4 is a graph illustrating a static contact angle between water, vinegar, and soy sauce measured according to a time of oxygen plasma processing performed on the food container. In this case, an x-axis indicates a time of oxygen plasma processing performed before coating the hydrophobic thin film and the gas blocking film, and a y-axis indicates a static contact angle measured in a state where a corresponding liquid droplet is stopped.

An experiment is performed by using a polypropylene (PP) sheet, which is a plastic material widely used as the food container.

In order to form the nano-structures on a surface of the PP sheet, dust on the surface of the PP sheet is first clearly blown by using a nitrogen gun for one minute, and then the PP sheet is positioned within the chamber of the Radio Frequency-Chemical Vapor Deposition (RF-CVD) equipment (not shown), and a vacuum state is formed.

A vacuum pressure within the chamber is decreased with high vacuum of 10-6 mtorr by using a rotary pump and a turbo pump, and then plasma processing starts to be performed on the surface of the PP sheet. To this end, after inserting oxygen gas into the chamber, the plasma state is formed by RF-power. Then, the plurality of nano-structures 20 is formed on the surface of the PP sheet by chemical reaction between the PP sheet and the oxygen plasma.

Then, the second hydrophobic thin film 50, the gas blocking film 40, the first hydrophobic thin film 30 are sequentially coated. In this case, the first hydrophobic thin film 30 and the second hydrophobic thin film 50 are formed of pp-hexamethyldisiloxane (pp-HMDSO), and the gas blocking film 40 is formed of silicon oxide.

Further, the first hydrophobic thin film 30 and the second hydrophobic thin film 50 are coated with a thickness of 30 nm, and the gas blocking film 40 is coated with a thickness of 30 nm.

As can be seen in the graph illustrated in FIG. 4, as the time of the oxygen plasma processing is increased, the contact angle is increased. That is, it can be seen that hydrophobicity of the surface of the PP sheet is improved.

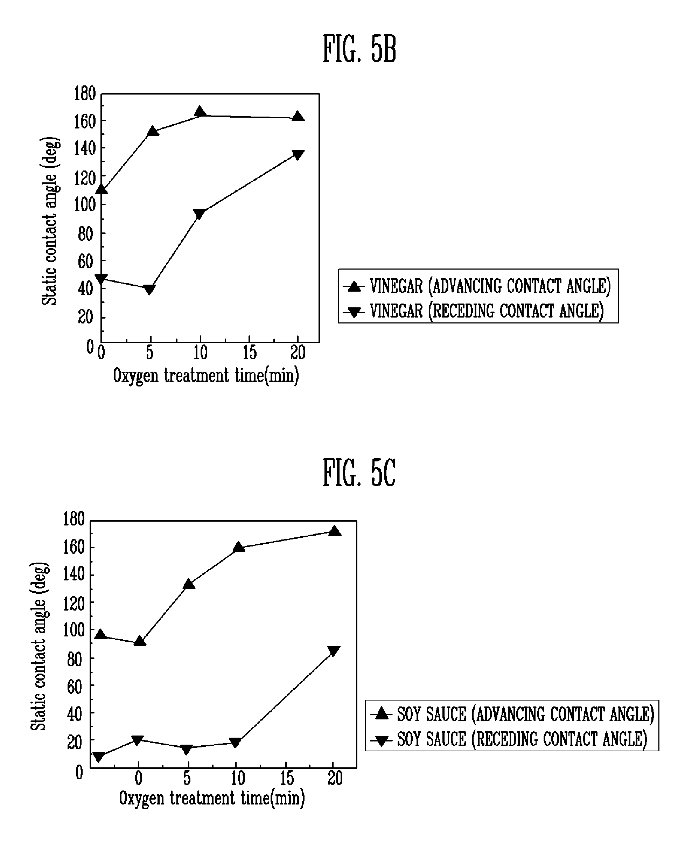

FIG. 5A is a graph illustrating a dynamic contact angle of water according to a time of oxygen plasma processing performed on the food container, FIG. 5B is a graph illustrating a dynamic contact angle of vinegar according to a time of oxygen plasma processing performed on the food container, and FIG. 5C is a graph illustrating a dynamic contact angle of soy sauce according to a time of oxygen plasma processing performed on the food container. In this case, an x-axis indicates a time of oxygen plasma processing performed before coating the hydrophobic thin film and the gas blocking film, and a y-axis indicates a dynamic contact angle.

Particularly, in order to recognize the contact angle hysteresis, an advancing contact angle and a receding contact angle of a corresponding liquid droplet are separately illustrated.

A fact that the contact angle hysteresis is small means that even though a surface is slightly inclined, the liquid easily flows down on the surface. That is, it means that as the contact angle hysteresis is small, the liquid is not attached to the surface. As can be seen in FIGS. 5A to 5C, as a time of the oxygen plasma processing is increased, the contact angle hysteresis of water, vinegar, and soy sauce is decreased.

It will be appreciated by those skilled in the art that the present invention described above may be implemented into other specific forms without departing from the technical spirit thereof or essential characteristics. Thus, it is to be appreciated that exemplary embodiments described above are intended to be illustrative in every sense, and not restrictive. The scope of the present invention is represented by the claims to be described below rather than the detailed description, and it is to be interpreted that the meaning and scope of the claims and all the changes or modified forms derived from the equivalents thereof come within the scope of the present invention.

### [Description of Main Reference Numerals of Drawings]

| | |
|---|---|
| 20: Nano-structure | 30: First hydrophobic thin film |
| 40: Gas blocking film | 50: Second hydrophobic thin film |
| 60: Food | 100, 200, 300: Food container |

## Claims

1. A food container made of a plastic material and having a nano-structured hydrophobic surface, comprising:
a plurality of nano-structures formed on a surface of the food container; and
a first hydrophobic thin film coated on an upper side of the surface, on which the nano-structures are formed.

2. The food container of claim 1, further comprising:
a gas blocking film formed between the surface of the food container and the first hydrophobic thin film.

3. The food container of claim 2, further comprising:
a second hydrophobic thin film formed between the surface of the food container and the gas blocking film.

4. The food container of claim 1, wherein the nano-structure has any one shape among a nano-pillar shape, a nano-rod shape, a nano-dot shape, and a nano-wire shape.

5. The food container of claim 1, wherein the nano-structure has a width of 1 to 100 nm and a height of 1 to 1000 nm.

6. The food container of claim 1, wherein a contact angle of the first hydrophobic thin film is equal to or larger than 90°, and contact angle hysteresis of the first hydrophobic thin film is less than 30°.

7. The food container of claim 2, wherein a sum of a thickness of the first hydrophobic thin film and a thickness of the gas blocking film is a half of a height of the nano-structure or lower.

8. The food container of claim 3, wherein a sum of a thickness of the first hydrophobic thin film, a thickness of the gas blocking film, and a thickness of the second hydrophobic thin film is a half of a height of the nano-structure or lower.

9. The food container of claim 1, wherein the first hydrophobic thin film is formed of hexamethyldisiloxane

10. The food container of claim 2, wherein the gas blocking film is formed of silicon oxide.

11. The food container of claim 3, wherein the second hydrophobic thin film is formed of hexamethyldisiloxane

12. The food container of claim 3, wherein the gas blocking film and the first and second hydrophobic thin films are discontinuously combined.

13. The food container of claim 3, wherein the gas blocking film and the first and second hydrophobic thin films are continuously combined according to a continuous change in mutual chemical composition.

14. A method of manufacturing a food container having a nano-structured hydrophobic surface, comprising:
forming a plurality of nano-structures on a surface of the food container formed of a plastic material; and
coating a first hydrophobic thin film on an upper side of the surface, on which the nano-structures are formed.

15. The method of claim 14, further comprising:
coating a gas blocking film on the upper side of the surface, on which the nano-structures are formed, between the forming of the plurality of nano-structures and the coating of the first hydrophobic thin film.

16. The method of claim 15, further comprising:
coating a second hydrophobic thin film on the upper side of the surface, on which the nano-structures are formed, between the forming of the plurality of nano-structures and the coating of the gas blocking film.

17. The method of claim 14, wherein the nano-structure has any one shape among a nano-pillar shape, a nano-rod shape, a nano-dot shape, and a nano-wire shape.

18. The method of claim 14, wherein the nano-structure has a width of 1 to 100 nm and a height of 1 to 1000 nm.

19. The method of claim 14, wherein a contact angle of the first hydrophobic thin film is equal to or larger than 90°, and contact angle hysteresis of the first hydrophobic thin film is less than 30°.

20. The method of claim 15, wherein a sum of a thickness of the first hydrophobic thin film and a thickness of the gas blocking film is a half of a height of the nano-structure or lower.

21. The method of claim 16, wherein a sum of a thickness of the first hydrophobic thin film, a thickness of the gas blocking film, and a thickness of the second hydrophobic thin film is a half of a height of the nano-structure or lower.

22. The method of claim 14, wherein the first hydrophobic thin film is formed of hexamethyldisiloxane

23. The method of claim 15, wherein the gas blocking film is formed of silicon oxide.

24. The method of claim 16, wherein the second hydrophobic thin film is formed of hexamethyldisiloxane

25. The method of claim 16, wherein the gas blocking film and the first and second hydrophobic thin films are discontinuously combined.

26. The method of claim 16, wherein the gas blocking film and the first and second hydrophobic thin films are continuously combined according to a continuous change in mutual chemical composition.
